# EUROPÄISCHE PATENTSCHRIFT

(11) **EP 2 885 645 B1**
(45) Veröffentlichungstag und Bekanntmachung des Hinweises auf die Patenterteilung: **15.06.2016**
(21) Anmeldenummer: 13770623.0
(22) Anmeldetag: 14.08.2013
(51) Int. Cl.: G01R 1/04, G01R 31/02, H01R 9/03, H01R 9/05, H01R 24/40, H01R 24/50, H01R 24/52, H01R 4/28, H01R 12/72, H01R 12/75

(54) **VORRICHTUNG UND VERFAHREN ZUR REVERSIBLEN, MECHANISCHEN FIXIERUNG UND ELEKTRISCHEN KONTAKTIERUNG ELEKTRISCHER LEITER**
DEVICE AND METHOD FOR REVERSIBLE MECHANICAL FIXATION AND ELECTRICAL CONTACTING OF ELECTRICAL CONDUCTORS
DISPOSITIF ET PROCÉDÉ DE FIXATION MÉCANIQUE ET DE CONNEXION ÉLECTRIQUE RÉVERSIBLES DE CONDUCTEURS ÉLECTRIQUES

(30) Priorität: 17.08.2012 DE 102012107556
(43) Veröffentlichungstag der Anmeldung: 24.06.2015
(73) Patentinhaber: HARTING Electronics GmbH, 32339 Espelkamp (DE)
(72) Erfinder: WITTE, Markus, 49393 Lohne (DE); FENNEN, Lars, 26810 Westoverledingen (DE)
(86) Internationale Anmeldenummer: PCT/DE2013/100293
(87) Internationale Veröffentlichungsnummer: WO 2014/026678

(56) Entgegenhaltungen:
- EP-A2- 0 848 459
- WO-A1-01/22097
- DE-A1- 10 157 640
- US-A1- 2004 185 708
- US-A1- 2005 208 828
- US-A1- 2011 306 235

## Beschreibung

Die Erfindung betrifft eine Vorrichtung zur reversiblen, mechanischen Fixierung und elektrischen Kontaktierung eines oder mehrerer elektrischer Leiter eines Kabels.
Des Weiteren betrifft die Erfindung ein Verfahren zur reversiblen, mechanischen Fixierung und elektrischen Kontaktierung eines oder mehrerer elektrischer Leiter eines Kabels.

Eine derartige Vorrichtung sowie ein derartiges Verfahren wird benötigt, um ein oder mehrere elektrische Leiter, die in einem Kabel geführt sind, temporär, elektrisch zu kontaktieren. Eine solche Kontaktierung ist vor allem zum elektrischen Messen von derartigen Kabeln nötig. Gerade im Bereich von Hochfrequenz-Messungen müssen Kabel wiederholbar mit einer gleichbleibenden Qualität gemessen werden können. Hierfür ist eine qualitativ einheitliche, elektrische Kontaktierung der Kabel nötig.

### Stand der Technik

Bislang wurden für solche Messungen die einzelnen elektrischen Leiter von Kabeln üblicherweise.an Messeinrichtungen gelötet, oder Steckverbinder angelötet, welche mit einer Messeinrichtung kontaktiert werden.

Dieser Lötvorgang ist zum einen sehr zeitaufwändig. Vor allem bei Kabeln mit geringen Leiterquerschnitten ist das Anlöten von Steckverbindern per Hand sehr aufwändig.

Zum anderen kann keine einheitliche Qualität der Lötstellen gewährleistet werden. Je nachdem wer und unter welchen Voraussetzungen der Lötvorgang durchführt wird, kann die Qualität der Lötstellen stark schwanken. Diese Schwankungen der Lötstellen haben gerade im Hochfrequenz-Bereich großen Einfluss auf die Messergebnisse.

Alternativ zum Anlöten von elektrischen Leitern ist aus der US 2005/208828 A1 eine Verbindungsstruktur mit einem Positionierungsblock und einem dielektrischen Substrat bekannt. Ein Koaxialkabel weist einen Endabschnitt auf, der in einem Durchgang in dem Positionierungsblock aufgenommen ist. Mittels des Positionierungsblocks kann die Stirnfläche des Koaxialkabels senkrecht auf dem dielektrischen Substrat positioniert werden.

Nachteilig an dieser Lösung ist, dass die Koaxialkabel mit ihrer Stirnseite auf die Substratoberfläche kontaktiert werden. Dies ist mit Koaxialkabeln - auch mehreren nebeneinander - möglich, jedoch für Kabel mit feineren Adern nicht geeignet. Zudem ist das Einführen der Koaxialkabel in einen derartigen Positionierungsblock sehr aufwändig und zeitintensiv.

### Aufgabenstellung

Der Erfindung liegt die Aufgabe zugrunde, eine Vorrichtung und ein Verfahren vorzustellen, mittels dessen elektrische Leiter von Kabeln auf einfache Art reversibel, mechanisch fixiert, für eine Kontaktierung an der Vorrichtung ausgerichtet und elektrisch kontaktiert werden können. Dabei soll eine Wiederholbarkeit bei gleichbleibender Qualität der Kontaktierung sichergestellt werden. Zudem soll die Kontaktierung zeitsparend erfolgen.

Diese Aufgabe wird durch den Gegenstand des unabhänigen Anspruchs 1 sowie das Verfahren des unabhängigen Anspruchs 14 gelöst.

Vorteilhafte Ausgestaltungen der Erfindung sind in den Unteransprüchen angegeben.

Bei der Erfindung handelt es sich um eine Vorrichtung, die im Wesentlichen aus drei Teilen besteht: eine Kabelaufnahme, eine Kontaktplatte und ein Fixierelement.

Die Kabelaufnahme dient zur Fixierung eines zu kontaktierenden Kabels. Dabei.wird das Ende des zu kontaktierenden Kabels über einen Bereich linear ausgerichtet und mechanisch von der Kabelaufnahme umfasst und so fixiert. Abisolierte, freiliegende Leiterenden des Kabels werden dabei nicht von der Kabelaufnahme umfasst. Diese stehen als letztes Ende über die Kabelaufnahme, zur elektrischen und mechanischen Kontaktierung hinaus.

Der Kabelaufnahme schließt sich am Ende der abisolierten, freiliegenden Leiterenden die Kontaktplatte an. Diese ist in etwa parallel zum linear ausgerichteten Kabel angeordnet. Auf der Kontaktplatte sind elektrische Leiterbahnen angeordnet, vorzugsweise in der Anzahl wie das Kabel über elektrische Leiter verfügt.

Jeweils ein Ende der elektrischen Leiterbahnen bildet einen Kontaktbereich auf der Kontaktplatte. Dieser liegt zweckmäßig am Randbereich der Kontaktplatte. An diesem Kontaktbereich schließt sich vorteilhaft die Kabelaufnahme mit den freiliegenden Leiterenden an die Kontaktplatte an.

Die Kabelaufnahme liegt so nah an der Kontaktplatte, dass die abisolierten, freiliegenden Leiterenden auf der Kontaktplatte aufliegen. Diese können so justiert werden, dass jeweils ein freiliegendes Leiterende auf einem der Kontaktbereich der elektrischen Leiterbahnen aufliegt.

In einer vorteilhaften Weiterbildung, ist eine Mechanik an der Kabelaufnahme vorgesehen. Mittels der Mechanik ist die Kabelaufnahme von der Kontaktplatte weg und zu dieser hin bewegbar. Vorzugsweise in einer linearen Bewegung. Die Bewegung der Kabelaufnahme dient zur Kontaktierung eines der freiliegenden Leiterenden - vorzugsweise eines im Kabel geführten Beilaufdrahtes.

Dabei wird das freiliegende Leiterende zwischen der Kabelaufnahme und der Stirnseite der Kontaktplatte eingeklemmt. Die Kontaktplatte verfügt für diese Ausbildungsform über einen weiteren Kontaktbereich, welcher sich an der Stirnseite der Kontaktplatte, hin zur Kabelaufnahme befindet.

In einer bevorzugten Ausbildungsform ist an dem weiteren Kontaktbereich zwischen Kontaktplatte und Kabelaufnahme ein elastisches, elektrisch leitendes Federelement vorgesehen. Der freiliegende Leiter wird mittels der Kabelaufnahme an das Federelement gedrückt, wodurch sich immer die gleiche, auf den freiliegenden Leiter wirkende Kraft ergibt. Das elektrisch leitende Federelement kontaktiert wiederum elektrisch den weiteren Kontaktbereich der Kontaktplatte.

Zur mechanischen Fixierung und elektrisch sicheren Kontaktierung der freiliegenden Leiterenden auf den Leiterbahnen im Kontaktbereich der Kontaktplatte ist das Fixierelement vorgesehen. Dieses ist über der Kontaktplatte im Kontaktbereich angeordnet und mittels einer Mechanik auf die Kontaktplatte bewegbar.

Das elektrisch isolierende Fixierelement besteht vorzugsweise aus einem elastischen Material. Mittels einer Mechanik - vorzugsweise eines Kniehebels - kann das Fixierelement auf den Kontaktbereich gedrückt werden. Durch das elastische, elektrisch isolierende Material werden die freiliegenden Leiterenden, die auf den Leiterbahnen positioniert sind, auf die Kontaktplatte gepresst.

Durch die immer einheitliche Fixierung des Kabels, die Positionierung der freiliegenden Leiterenden und das Anpressen dieser mittels des Fixierelements auf den Leiterbahnen ist eine wiederholbare, qualitativ gleichbleibende elektrische Kontaktierung der elektrischen Leiter gegeben. Durch Anschluss einer Messeinrichtung an den Leiterbahnen ist so eine gleichbleibende und wiederholbare Messung von Kabeln möglich.

In einer weiteren vorteilhaften Ausführungsform sind mehrere der erfindungsgemäßen Vorrichtungen zusammen angeordnet. Dadurch können auch Kabel kontaktiert werden, die eine Vielzahl von elektrischen Leiterpaaren aufweisen. Diese können so paarweise in die Vorrichtung eingelegt und kontaktiert werden.

Besonders vorteilhaft ist es dabei, die Vorrichtungen kreisförmig anzuordnen. Dadurch sind die Längen der einzelnen, freiliegenden Leiterpaare des Kabels identisch, was für beispielsweise eine Messung der Kabel vorteilhaft ist.

Weitere Ausgestaltungen der Erfindung sind in den Unteransprüchen beschrieben.

### Ausführungsbeispiel

Ein Ausführungsbeispiel der Erfindung ist in der Zeichnung dargestellt und wird im Folgenden näher erläutert. Es zeigen:
- Fig. 1: eine Vorrichtung gemäß der vorliegenden Erfindung in räumlicher Ansicht,
- Fig. 2: eine Vorrichtung aus Fig. 1 in detaillierterer räumlicher Ansicht,
- Fig. 3: eine Detailansicht von fixierten und kontaktierten, freiliegen Leiterenden,
- Fig. 4: einen Kontaktbereich mit kontaktierten Leitern, und
- Fig. 5: eine Kontaktplatte in räumlicher Ansicht.

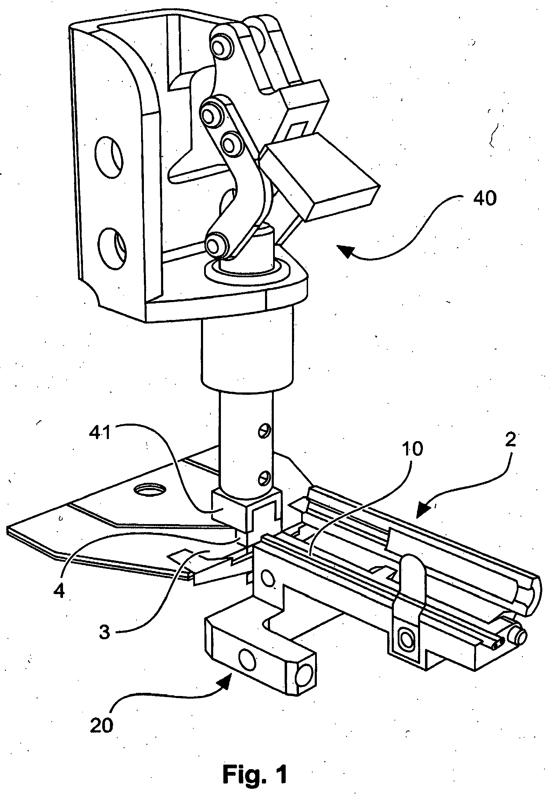

In der Fig.1 ist eine Vorrichtung gemäß der vorliegenden Erfindung in räumlicher Ansicht dargestellt. Im Wesentlichen besteht die Vorrichtung aus einer Kabelaufnahme 2, einer Kontaktplatte 3 und einem Fixierelement 4.

In der geöffneten Kabelaufnahme 2 ist ein Kabel 10 gezeigt, welches mittels der Vorrichtung mechanisch fixiert und elektrisch kontaktiert werden soll. Des Weiteren ist eine Mechanik 20 gezeigt, welche zur linearen Bewegung der Kabelaufnahme 2 weg von der Kontaktplatte 3, und hin zu dieser dient. Oberhalb des Fixierelements 4 ist eine weitere Mechanik 40 dargestellt, welche zur Bewegung des Fixierelements 4 weg von der Kontaktplatte 3, und hin zu dieser dient.

Die Mechanik 40 ist in dieser Ausführungsform als Kniehebel ausgebildet. Jedoch sind auch andere Ausführungsformen zum Beispiel in Form einer Gewindestange oder einer Zahnstange denkbar.

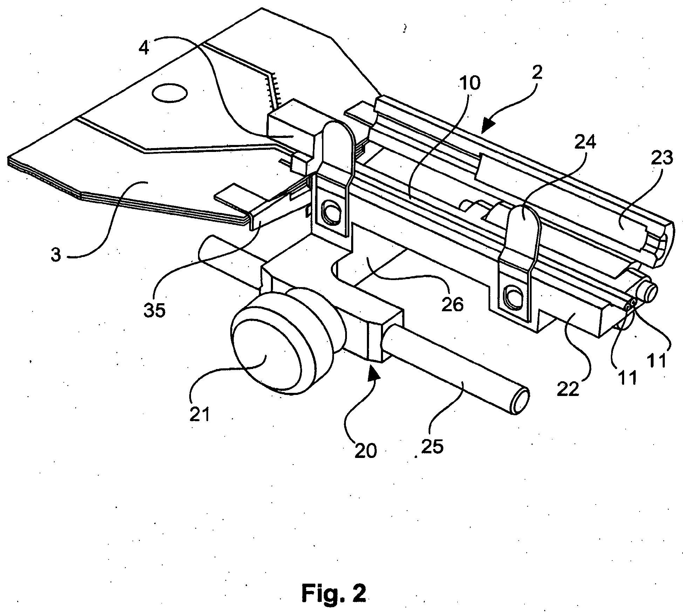

Die Fig. 2 zeigt eine detailliertere Ansicht der in Fig. 1 gezeigten Vorrichtung. Die Kabelaufnahme 2 wird von einer Kabelauflage 22 gebildet. Die Kabelauflage 22 ist über ein Scharnier mit einem Kabeldeckel 23 verbunden. Wird der Kabeldeckel 23 auf die Kabelauflage 22 geklappt, fixieren beide zusammen das eingelegte Kabel 10.

Eine Deckelklemme 24 verhindert das Öffnen von Kabeldeckel 23 und Kabelauflage 22. in diesem Ausführungsbeispiel ist die Deckelklemme 24 lediglich ein Federblech in welches der Kabeldeckel 23 einrastet. Auch sind aufwendigere Verschlussanordnungen denkbar.

Die Kabelaufnahme 2 ist auf einem Kabelschlitten 26 angebracht. Dieser bildet zusammen mit hier zwei Schlittenführungen 25 und einer Spannschraube 21 die Mechanik 20 zur Bewegung der Kabelaufnahme 2. Dabei kann der Kabelschlitten 26 auf den beiden Schlittenführungen 25 linear zu der Kontaktplatte 3 hin und von dieser weg bewegt werden. Mittels der Spannschraube 21 kann der Kabelschlitten 26 in einer Position fixiert werden.

Die in einem Gehäuse - hier nicht gezeigt - angeordnete Kontaktplatte 3 ist zu erkennen. Auf die Kontaktplatte 3 drücke das Fixierelement 4, welches von einer Aufnahme 41 gehalten wird. Die Aufnahme 41 ist wiederum an der Mechanik 40 - ebenfalls nicht gezeigt - befestigt, welche eine Bewegung des Fixierelements 4 ermöglicht.

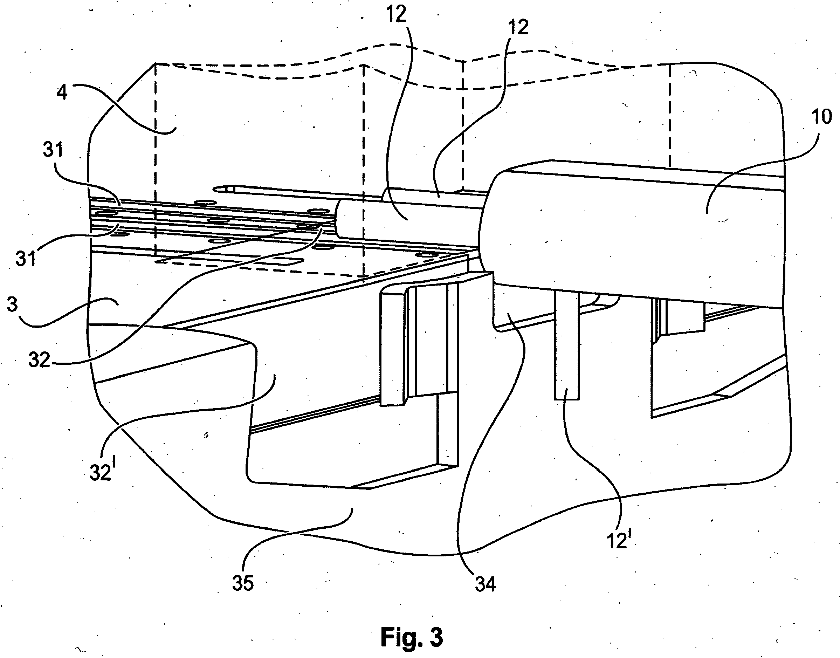

Zwischen der Kabelaufnahme 2 und der Kontaktplatte 3 ist ein Federelement 35 erkennbar. Dies dient zur zusätzlichen Kontaktierung eines im Kabel 10 verlaufenden weiteren elektrischen Leiters 11', welcher hier als Beilaufdraht ausgebildet ist. Die Funktion des Federelements 35 wird in Fig. 3 näher beschrieben.

In Fig. 3 ist in einer detaillierten Ansicht die mechanisch Fixierung und elektrisch Kontaktierung von freiliegenden Leiterenden 12, 12' dargestellt. Zur besseren Darstellung ist die Kabelaufnahme 2 in dieser Ansicht nicht dargestellt. Diese würde das Kabel 10 umgeben.

Die freiliegenden Leiterenden 12 liegen auf den elektrischen Leiterbahnen 31 im Kontaktbereich 32 auf der Kontaktplatte 3 auf. Mittels des Fixierelements 4 werden die freiliegenden Leiterenden 12 auf die elektrischen Leiterbahnen 31 gepresst. So kann eine sichere, elektrische Kontaktierung der freiliegenden Leiterenden 12 auf die Leiterbahnen 31 gewährleistet werden.

Im unteren Bereich ist das Federelement 35 erkennbar. Dieses ist so an der Stirnseite 34 der Kontaktplatte 3 positioniert, dass es der - hier nicht dargestellten - Kabelaufnahme 2 zugewandt ist und einen weiteren Kontaktbereich 32' der Kontaktplatte 3 elektrisch kontaktiert.

Der weitere Kontaktbereich 32' des Kontaktplatte 3 ist an deren Stirnseite 34 angeordnet und wird von einer weiteren elektrischen Leiterbahn 31' gebildet. Diese dient in erster Linie zur Kontaktierung eines im Kabel 10 geführten weitern elektrischen Leiters 11', der als Beilaufdraht zu den elektrischen Leitern 11 verläuft.

Zur Kontaktierung des weiteren elektrischen Leiters 11' wird das freiliegende Leiterende 12' nicht auf die Kontaktplatte 2 in den Kontaktbereich 32 geführt, sondern senkrecht nach unten gebogen um das Federelement 35 zu kontaktieren. Um eine sichere Kontaktierung zu gewährleisten wird das weitere freiliegende Leiterende 12' zwischen dem Federelement 35 und der hier nicht gezeigten Kabelaufnahme 2 eingeklemmt. Dies geschieht durch verschieben der Kabelaufnahme 2 in Richtung der Stirnseite 34 der Kontaktplatte 3.

Dadurch, dass der weitere elektrische Leiter 11' nicht direkt auf den weiteren Kontaktbereich 32' gedrückt wird, sondern gegen das Federelement 35, kann eine gleichbleibende Kraft und somit Kontaktierung des Leiters 11' sichergestellt werden. Unabhängig davon wie weit die Kabelaufnahme 2 an die Kontaktplatte 3 herangeführt wird.

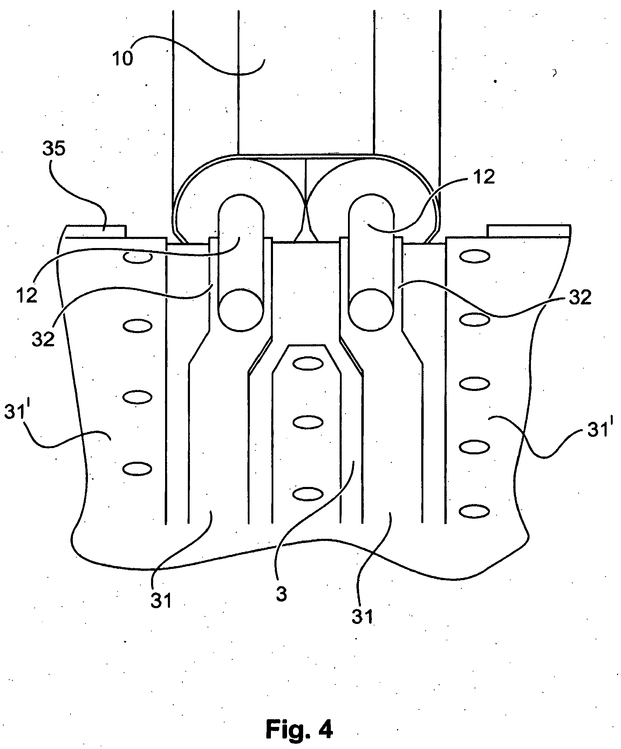

Der Kontaktbereich 32 der Kontaktplatte 2 mit kontaktierten freiliegenden Leiterenden 12 ist in Fig. 4 detaillierter dargestellt. Auf den, den Kontaktbereich 32 bildenden, elektrischen Leiterbahnen 31 liegen die freiliegenden Leiterenden 12 des Kabels 10 auf.

In den äußeren Bereichen der Fig. 4 sind weitere elektrischen Leiterbahnen 31' dargestellt, welche an der Stirnseite 34 der Kontaktplatte 3 einen weiteren Kontaktbereich 32' bilden. An diesem weitern Kontaktbereich 32' ist das Federelement 35 vorgesehen welches den weiteren Kontaktbereich 32' elektrisch kontaktiert.

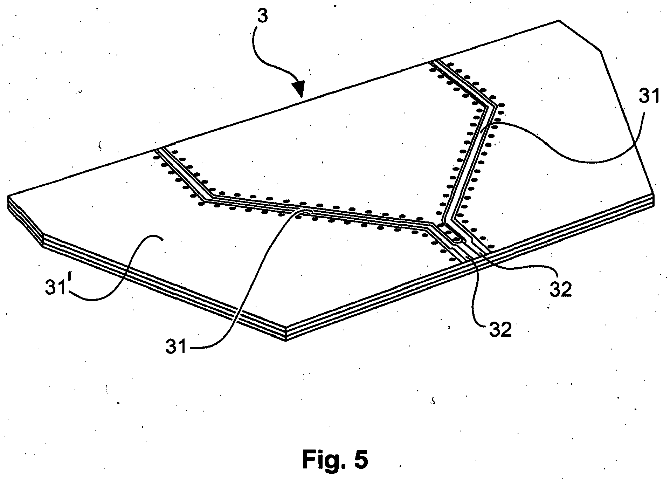

Die elektrischen Leiterbahnen 31, 31' sind in Fig. 5, in einer räumlichen Ansicht der Kontaktplatte 3 noch einmal dargestellt. Erkennbar sind die im Kontaktbereich 32 eng aneinander liegenden elektrischen Leiterbahnen 31, die im hinteren Bereich der Kontaktplatte 3 weiter auseinander gezogen sind und eine Kontaktierung zur Signalweiterführung zu ermöglichen. Hier wäre sowohl ein Steckverbinder, der auf die Kontaktplatte 3 aufgebracht wird denkbar, oder auch das dauerhafte Anlöten eines Kabels.

### Vorrichtung und Verfahren zur reversiblen, mechanischen Fixierung und

### elektrischen Kontaktierung elektrischer Leiter

### Bezugszeichenliste

- 2.: Kabelaufnahme
- 3.: Kontaktplatte
- 4.: Fixierelement

- 10.: Kabel
- 11.: elektrischer Leiter
- 12.: freiliegendes Leiterende

- 20.: Mechanik der Kabelaufnahme 2
- 21.: Spannschraube
- 22.: Kabelauflage
- 23.: Kabeldeckel
- 24.: Deckelklemme
- 25.: Schlittenführung
- 26: Kabelschlitten

- 31.: elektrische Leiterbahn
- 32.: Kontaktbereich
- 34.: Stirnseite
- 35.: Federelement

- 40.: Mechanik des Fixierelements 4
- 41.: Aufnahme

## Patentansprüche

1. : Vorrichtung zur reversiblen, mechanischen Fixierung, sowie
elektrischen Kontaktierung eines oder mehrerer elektrischer Leiter (11) eines Kabels (10),
• bestehend aus einer Kabelaufnahme (2), einer Kontaktplatte (3) und einem Fixierelement (4),
• wobei in der Kabelaufnahme (2) das Kabel (10) mit mindestens einem darin verlaufenden elektrischen Leiter (11) mechanisch reversibel fixierbar ist,
• wobei die Kontaktplatte (3) über mindestens eine elektrische Leiterbahn (31) verfügt, auf welche ein freiliegendes Leiterende (12) des mindestens einen elektrischen Leiters (11) kontaktierbar ist, und
• die Kontaktplatte (3) einen Kontaktbereich (32) aufweist, der von einem Ende der mindestens einen elektrischen Leiterbahn (31) gebildet wird,
• wobei das Fixierelement (4) über eine Mechanik (40) verfügt, welche es ermöglicht, das Fixierelement (4) auf die Kontaktplatte (3) und von dieser weg zu bewegen,
**dadurch gekennzeichnet, dass**
• die Kabelaufnahme (2) an einer Stirnseite (34) der Kontaktplatte (3) angeordnet ist, so dass ein in der Kabelaufnahme (2) fixierbares Kabel (10) von der Kontaktplatte (3) wegführbar ist, und dass
• die Kabelaufnahme (2) über eine Mechanik (20) verfügt, welche es ermöglicht, die Kabelaufnahme (2) zur Stirnseite (34) der Kontaktplatte (3) und von dieser weg zu bewegen.

2. Vorrichtung nach Anspruch 1, **dadurch gekennzeichnet, dass** die mindestens eine elektrische Leiterbahn (31) mit dem nicht den Kontaktbereich (32) bildenden Ende mit einem elektrischen Steckverbinder verbunden ist.

3. Vorrichtung nach einem der Ansprüche 1 oder 2, **dadurch gekennzeichnet,**
**dass** die Kontaktplatte (3) mindestens eine weitere elektrische Leiterbahn (31') aufweist, welche einen weiteren Kontaktbereich (32') bildet.

4. Vorrichtung nach einem der vorstehenden Ansprüche, **dadurch gekennzeichnet,**
**dass** die Kabelaufnahme (2) so ausgerichtet ist, dass ein in der Kabelaufnahme (2) fixierbares Kabel (10) zumindest bereichsweise in etwa parallel zur Oberfläche des Kontaktplatte (3) verläuft und das freiliegende Leiterende (12) des mindestens einen elektrischen Leiters (11) auf dem Kontaktbereich (32) der Kontaktplatte (3) aufliegt.

5. Vorrichtung nach einem der vorstehenden Ansprüche, **dadurch gekennzeichnet,**
**dass** die Kontaktplatte (3) an der der Kabelaufnahme (2) zugewandten Stirnseite (34) den weiteren Kontaktbereich (32') aufweist.

6. Vorrichtung nach einem der vorstehenden Ansprüche, **dadurch gekennzeichnet,**
• **dass** an dem weiteren Kontaktbereich (32') der Kontaktplatte (3) ein elektrisch leitendes Federelement (35) vorgesehen ist,
• wobei das Federelement (35) zwischen dem Kontaktbereich (32') und der Kabelaufnahme (2) angeordnet ist.

7. Vorrichtung nach einem der vorstehenden Ansprüche, **dadurch gekennzeichnet,**
**dass** das Fixierelement (4) aus einem elastisch verformbaren, elektrisch nicht leitenden Material besteht.

8. Vorrichtung nach einem der vorstehenden Ansprüche, **dadurch gekennzeichnet,**
**dass** das Fixierelement (4) mittels der Mechanik (40) auf die mindestens eine elektrische Leiterbahn (31) der Kontaktplatte (3) pressbar ist.

9. Vorrichtung nach einem der vorstehenden Ansprüche, **dadurch gekennzeichnet,**
**dass** die Mechanik (40) zum bewegen des Fixierelements (4) ein Kniehebel ist.

10. Vorrichtung nach einem der vorstehenden Ansprüche, **dadurch gekennzeichnet,**
**dass** die Mechanik (20) dazu geeignet ist, die Kabelaufnahme (2) linear zur Kontaktplatte (3) und von dieser weg zu bewegen.

11. Vorrichtung nach Anspruch 10, **dadurch gekennzeichnet,**
**dass** die Mechanik (20) aus einem Kabelschlitten (26) gebildet wird, welcher auf zumindest einer Schlittenführung (25) linear verschiebbar angeordnet ist und mittels einer Spannschraube (21) in seiner Position auf der zumindest einen Schlittenführung (21) fixierbar ist.

12. Vorrichtung nach einem der vorstehenden Ansprüche, **dadurch gekennzeichnet,**
**dass** mehrere der Vorrichtungen nebeneinander angeordnet sind, um Kabeln (10) mit einer Vielzahl von elektrischen Leitern (11) zu kontaktieren.

13. Vorrichtung nach Anspruch 12, **dadurch gekennzeichnet, dass** die mehreren Vorrichtungen kreisförmig angeordnet sind.

14. Verfahren zur reversiblen, mechanischen Fixierung, sowie elektrischen Kontaktierung mehrerer elektrischer Leiter (11) eines Kabels (10) mit den folgenden Schritten:
• Fixierung des Kabels (10) in einer Kabelaufnahme (2),
• Verklemmen eines elektrischen Leiters (11') zwischen der Kabelaufnahme (2) und einer Stirnseite (34) einer Kontaktplatte (3) durch Verschieben der Kabelaufnahme (2) an die Stirnseite (34) der Kontaktplatte (3),
• Positionierung von einem oder mehreren freiliegenden Leiterenden (12) des einem oder der mehreren elektrischen Leiter (11) auf der Kontaktplatte (3),
• Anpressen des einen oder der mehreren freiliegenden Leiterenden (12) auf der Kontaktplatte (3) mittels eines Fixierelements (4).

## Claims

1. Apparatus for reversibly mechanically fixing and making electrical contact with one or more electrical conductors (11) of a cable (10),
• comprising a cable holder (2), a contact plate (3) and a fixing element (4),
• wherein the cable (10), together with at least one electrical conductor (11) which runs in the said cable, can be fixed in a mechanically reversible manner in the cable holder (2),
• wherein the contact plate (3) has at least one electrical conductor track (31) on which contact can be made with an exposed conductor end (12) of the at least one electrical conductor (11), and
• the contact plate (3) has a contact region (32) which is formed by one end of the at least one electrical conductor track (31),
• wherein the fixing element (4) has a mechanism (40) which allows the fixing element (4) to move onto the contact plate (3) and away from the said contact plate, **characterized in that**
• the cable holder (2) is arranged on an end face (34) of the contact plate (3), so that a cable (10) which can be fixed in the cable holder (2) can be guided away from the contact plate (3), and **in that**
• the cable holder (2) has a mechanism (20) which allows the cable holder (2) to move towards the end face (34) of the contact plate (3) and away from the said end face of the contact plate.

2. Apparatus according to Claim 1, **characterized in that** the at least one electrical conductor track (31) is connected, by way of the end which does not form the contact region (32), to an electrical plug connector.

3. Apparatus according to either of Claims 1 and 2, **characterized**
**in that** the contact plate (3) has at least one further electrical conductor track (31') which forms a further contact region (32').

4. Apparatus according to one of the preceding claims, **characterized**
**in that** the cable holder (2) is oriented such that a cable (10) which can be fixed in the cable holder (2) runs, at least in regions, approximately parallel to the surface of the contact plate (3), and the exposed conductor end (12) of the at least one electrical conductor (11) rests on the contact region (32) of the contact plate (3).

5. Apparatus according to one of the preceding claims, **characterized**
**in that** the contact plate (3) has, on that end face (34) which faces the cable holder (2), the further contact region (32').

6. Apparatus according to one of the preceding claims, **characterized**
• **in that** an electrically conductive spring element (35) is provided on the further contact region (32') of the contact plate (3),
• wherein the spring element (35) is arranged between the contact region (32') and the cable holder (2).

7. Apparatus according to one of the preceding claims, **characterized**
**in that** the fixing element (4) is composed of an elastically deformable, electrically non-conductive material.

8. Apparatus according to one of the preceding claims, **characterized**
**in that** the fixing element (4) can be pressed, by means of the mechanism (40), onto the at least one electrical conductor track (31) of the contact plate (3).

9. Apparatus according to one of the preceding claims, **characterized**
**in that** the mechanism (40) for moving the fixing element (4) is a toggle lever.

10. Apparatus according to one of the preceding claims, **characterized**
**in that** the mechanism (20) is suitable for moving the cable holder (2) in a linear manner towards the contact plate (3) and away from the said contact plate.

11. Apparatus according to Claim 10, **characterized in that** the mechanism (20) is formed from a cable slide (26) which is arranged in a linearly moveable manner on at least one slide guide (25) and can be fixed in its position on the at least one slide guide (21) by means of a clamping screw (21).

12. Apparatus according to one of the preceding claims, **characterized**
**in that** a plurality of the apparatuses are arranged next to one another in order to make contact with cables (10) having a large number of electrical conductors (11).

13. Apparatus according to Claim 12, **characterized in that** the plurality of apparatuses are arranged in a circle.

14. Method for reversibly mechanically fixing and making electrical contact with a plurality of electrical conductors (11) of a cable (10), comprising the following steps:
• fixing the cable (10) in a cable holder (2),
• clamping an electrical conductor (11') between the cable holder (2) and an end face (34) of a contact plate (3) by moving the cable holder (2) against the end face (34) of the contact plate (3),
• positioning one or more exposed conductor ends (12) of the one or more electrical conductors (11) on the contact plate (3),
• pressing the one or more exposed conductor ends (12) onto the contact plate (3) by means of a fixing element (4).

## Revendications

1. Dispositif destiné à fixer mécaniquement, ainsi qu'à connecter électriquement de manière réversible un ou plusieurs conducteurs électriques (11) d'un câble (10),
- constitué d'un support de câble (2), d'une plaque contact (3) et d'un élément de fixation (4),
- dans lequel le câble (10) peut être fixé mécaniquement de manière réversible dans le support de câble (2) au moyen d'au moins un conducteur électrique (11) passant dans celui-ci,
- dans lequel la plaque de contact (3) comporte au moins une piste électriquement conductrice (31) avec laquelle une extrémité libre de conducteur (12) de l'au moins un conducteur électrique (11) peut être mise en contact, et
- la plaque de contact (3) comporte une zone de contact (32) qui est formée par une extrémité de l'au moins une piste électriquement conductrice (31),
- dans lequel l'élément de fixation (4) comporte un mécanisme (40) qui permet de déplacer l'élément de fixation (4) sur la plaque de contact (3) et de l'en écarter,
**caractérisé en ce que**
- le support de câble (2) est disposé sur une face avant (34) de la plaque de contact (3) de manière à ce qu'un câble (10) pouvant être fixé dans le support de câble (2) puisse être enlevé de la plaque de contact (3), et **en ce que**
- le support de câble (2) comporte un mécanisme (20) qui permet de déplacer le support de câble (2) vers la face avant (34) de la plaque de contact (3) et de l'en écarter.

2. Dispositif selon la revendication 1, **caractérisé en ce que** l'au moins une piste électroniquement conductrice (31) est reliée par l'extrémité ne formant pas la zone de contact (32) à un connecteur électrique.

3. Dispositif selon l'une quelconque des revendications 1 ou 2,
**caractérisé en ce que** la plaque de contact (3) comprend au moins une autre piste électriquement conductrice (31') qui forme une autre zone de contact (32').

4. Dispositif selon l'une quelconque des revendications précédentes,
**caractérisé en ce que** le support de câble (2) est conçu de manière à ce qu'un câble (10) pouvant être fixé dans le support de câble (2) s'étende, au moins dans certaines zones, sensiblement parallèlement à la surface de la plaque de contact (3) et **en ce que** l'extrémité libre de conducteur (12) de l'au moins un conducteur électrique (11) repose sur la zone de contact (32) de la plaque de contact (3).

5. Dispositif selon l'une quelconque des revendications précédentes,
**caractérisé en ce que** la plaque de contact (3) comporte l'autre zone de contact (32') sur la face avant (34) tournée vers le support de câble (2).

6. Dispositif selon l'une quelconque des revendications précédentes,
**caractérisé**
- **en ce qu'**il est prévu sur l'autre zone de contact (32') de la plaque de contact (3) un élément à ressort électriquement conducteur (35),
- dans lequel l'élément à ressort (35) est disposé entre la zone de contact (32') et le support de câble (2).

7. Dispositif selon l'une quelconque des revendications précédentes,
**caractérisé en ce que** l'élément de fixation (4) est constitué d'un matériau non électriquement conducteur déformable élastiquement.

8. Dispositif selon l'une quelconque des revendications précédentes,
**caractérisé en ce que** l'élément de fixation (4) peut être comprimé au moyen du mécanisme (40) sur l'au moins une piste électriquement conductrice (31) de la plaque de contact (3).

9. Dispositif selon l'une quelconque des revendications précédentes,
**caractérisé en ce que** le mécanisme (40) est un levier coudé destiné à déplacer l'élément de fixation (4).

10. Dispositif selon l'une quelconque des revendications précédentes,
**caractérisé en ce que** le mécanisme (20) est approprié pour déplacer linéairement le support de câble (2) vers la plaque de contact (3) et pour l'en écarter linéairement.

11. Dispositif selon la revendication 10, **caractérisé en ce que** le mécanisme (20) est formé par une fente de câble (26) qui est disposée de manière à pouvoir être déplacée linéairement sur au moins un guide à fente (25) et peut être fixée à sa position sur l'au moins un guide à fente (21) au moyen d'une vis de serrage (21).

12. Dispositif selon l'une quelconque des revendications précédentes,
**caractérisé en ce que** de multiples dispositifs sont disposés côte à côte afin de connecter des câbles (10) à une pluralité de conducteurs électriques (11).

13. Dispositif selon la revendication 12, **caractérisé en ce que** les multiples dispositifs sont agencés sous la forme d'un cercle.

14. Procédé destiné à fixer mécaniquement, ainsi que de connecter de manière réversible électriquement plusieurs conducteurs électriques (11) d'un câble (10), comportant les étapes consistant à :
- fixer le câble (10) dans un support de câble (2),
- serrer un conducteur électrique (11') entre le support de câble (2) et une face avant (34) d'une plaque contact (3) en déplaçant le support de câble (2) sur la face avant (34) de la plaque de contact (3),
- positionner une ou plusieurs extrémités libres de conducteurs (12) desdits un ou plusieurs conducteurs électriques (11) sur la plaque de contact (3),
- comprimer lesdites une ou plusieurs extrémités libres de conducteurs (12) sur la plaque de contact (3) au moyen d'un élément de fixation (4).
